(19) Europäisches Patentamt / European Patent Office / Office européen des brevets

(11) **EP 4 140 262 B1**

(12) **EUROPEAN PATENT SPECIFICATION**

(45) Date of publication and mention
of the grant of the patent:
**17.07.2024 Bulletin 2024/29**

(21) Application number: **21722582.0**

(22) Date of filing: **23.04.2021**

(51) International Patent Classification (IPC):
**H05K 1/09** *(2006.01)* **H05K 3/12** *(2006.01)*
**H05K 3/20** *(2006.01)*

(52) Cooperative Patent Classification (CPC):
**H05K 3/207; H05K 1/092; H05K 1/095;**
**H05K 3/1275;** H05K 3/1258; H05K 2203/0113;
H05K 2203/0126; H05K 2203/0134;
H05K 2203/0139; H05K 2203/0522;
H05K 2203/0528; H05K 2203/0783;
H05K 2203/083; H05K 2203/1105; H05K 2203/1115

(86) International application number:
**PCT/NL2021/050270**

(87) International publication number:
**WO 2021/215929 (28.10.2021 Gazette 2021/43)**

(54) **PATTERN TRANSFER OF HIGH VISCOSITY MATERIAL**

MUSTERÜBERTRAGUNG VON HOCHVISKOSEM MATERIAL

TRANSFERT DE MOTIF DE MATÉRIAU HAUTE VISCOSITÉ

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **24.04.2020 EP 20171361**

(43) Date of publication of application:
**01.03.2023 Bulletin 2023/09**

(73) Proprietor: **Nederlandse Organisatie voor**
**Toegepast-Natuurwetenschappelijk Onderzoek**
**TNO**
**2595 DA 's-Gravenhage (NL)**

(72) Inventor: **HENDRIKS, Rob Jacob**
**2595 DA 's-Gravenhage (NL)**

(74) Representative: **V.O.**
**P.O. Box 87930**
**2508 DH Den Haag (NL)**

(56) References cited:
**US-A- 5 992 320** **US-A1- 2002 096 512**
**US-A1- 2017 268 100**

**Description**

FIELD OF INVENTION

The invention relates to a transfer method of a high viscosity functional material, such as a conductive paste, on a substrate.

BACKGROUND

Interconnection of discrete bare chip components or microelectronic components (chips) on a substrate is a process for which precision material deposition with sufficient accuracy is necessary to allow for miniature electrical or other type of interconnects so that when a chip component becomes attached to a placement position all electrical connection and fixation to the substrate can be made by a conductive material or paste. An example of a conductive adhesives is a thermal or UV settable resin loaded with silver particles, or a solder paste comprising solder particles and flux. A common method for selectively depositing a functional material on a substrate is via printing. Typically a functional material needs to be formulated with other materials before the functional material can be printed on a substrate. A formulation can e.g. be formed by dispersing the functional material in a solvent or liquid; thus, the formulation is generally wet. The formulation is often referred to as an ink or paste, depending on the viscosity. A challenge exists to transfer such functional materials, since ideally, instead of printing a functional ink material on a substrate, selectively depositing only the pure functional material on a substrate is most preferable. Such materials e.g. consist of more than 50 vol% e.g. even 90 vol% of a solid state material such as a conductive polymer. Due to their highly viscous nature, e.g. higher than 50 Pa/s to even as much about 1000 Pa/s (10^6 cps). Such materials will not significantly deform due to gravity and flow, but substantial maintain the intended aspect ratio and form definition in the transfer. In US20170268100 a transfer method is described, also known as photonic printing, where a transparent transfer plate having cavities formed therein, that are filled with a functional material. The transfer plate is irradiated with pulsed light to heat a layer of light-absorbing material in order to generate gas at an interface between the layer of light absorbing material and the functional material, to release the functional material from the cavities. The problem with this method is ununiform ink release due to shadow effects. Especially for high aspect ratio cavities that are closely packed, the light only reaches the sides with difficulty. Uniform release of the ink results in poor print qualities, especially when high resolution patterns are transferred over relatively large distances. Furthermore, to properly transfer feature sizes of 5 - 10 $\mu$m without overheating the ink, the heat flux needs to be at least 40 kW/cm2 in the order of microseconds, which are unrealistic operation conditions for flashlamps. Another problem is that the method is only suitable for global transfer of structures designed via the patterned cavities provided in the substrate, as the light is not selective. Ideally patterns can be selectively formed and transferred, depending on a required pattern.

SUMMARY OF THE INVENTION

The prior art assembly has failed to provide an adequate method for high resolution bonding of fine pitch transfers on a substrate providing enough flexibility and reliability, for which the invention seeks a solution. To this end, it is proposed to provide a device and transfer method of a high viscosity functional material, such as a conductive paste, onto a receiving substrate (20).

In an aspect the invention pertains to transfer device for transferring a viscous functional material, such as a conductive paste, onto a receiving substrate. The device comprises a plate having a cavity surface that includes at least one cavity. The plate, e.g. a plate patterned a plurality of cavities, further comprises at least a thermal insulator layer formed of a thermally insulating material, e.g. glass (silica or the like). The at least one cavity is formed in the thermal insulator layer. The at least one cavity is provided with a thermal conductor. The thermal conductor is formed of a material having a high thermal conductivity, e.g. silicon or a metal such as copper or aluminum and the like. The thermal conductor extends along, and is restricted to, the cavity surface, e.g. as a layer or coating covering bottom and side wall surfaces of the cavity. The cavity can thus be understood to be defined or formed by said thermal conductor in the thermal insulator layer. The transfer device further comprises at least a resistive device that is in thermal contact with the thermal conductor and control circuitry connected to said resistive heating device. Thermal contact may be provided by direct contact. Alternatively thermal contact may be provided via one or more intermediate layers. The control circuitry is arranged to heat the resistive heating device, so as to, in use, generate a gas at an interface between said cavity surface in the cavity and a functional material provided in said cavity by heating the thermal conductor to transfer said functional material from said at least one cavity by said gas generation onto a receiving substrate. The resistive device is provided as a resistive layer parallel to the plate.

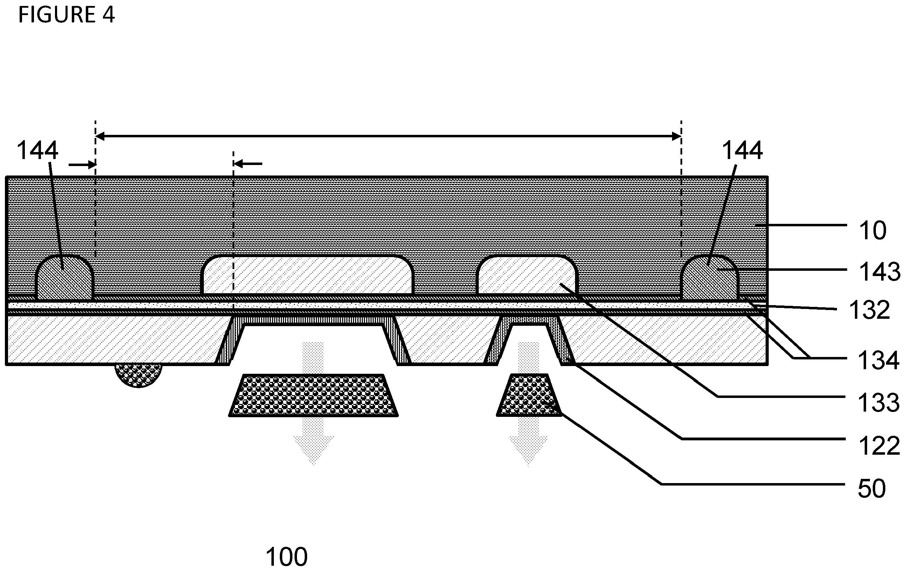

Advantageously, transfer devices as disclosed herein mitigate transfer, drying add/or curing of material of residual material present outside the transfer pattern, e.g. residues deposited next to a cavity a filling cycle with a doctor blade, cf the hemispherical droplet on the surface of the thermal insulator layer as depicted in FIG 4.

This advantage, in particular over devices having uniform or global heating such as devices heated by light pulses, is realized because, in use, the device generates thermal contrast between transfer areas of the device, the cavities having a heat spreader, and non-transfer areas, e.g. the surface of the thermal insulator next to the cavities.

The patterned plate can be filled with the functional material in a convenient and/or rapid way, e.g. by spreading a paste across the plate with a doctor blade.

To maximize the heat contrast the thermal diffusivity of the material forming the heatspreader divided by the thermal diffusivity of the material forming the thermally insulating layer of the plate is preferably as large as possible. A minimum ratio can be understood to about 10, a better ratio is >50, preferably the ratio is at least 100. For example, copper and glass form a suitable pair of materials.

In another of further aspect, the invention pertains to a method of transferring a high viscosity functional material, such as a conductive paste, onto a receiving substrate. The method comprising the steps of: providing a device according to the invention; e.g. a plate having a cavity surface that includes at least one cavity as disclosed herein; and providing a functional material in the at least one cavity, having a material composition that, when heated by the heating device, generates a gas at an interface between said cavity surface in the cavity and said functional material, to transfer said functional material from said at least one cavity by said gas generation onto the receiving substrate. Said functional material may be provided with a solvent and a solid state composition of more than 50 vol % solid state material. Said functional material may be a conductive ink, e.g. conductive adhesive material, such as an electroconductive polymer, a metallized polymer or a solder paste or adhesive.

BRIEF DESCRIPTION OF THE FIGURES

Figure 1 (A and B) shows a schematic disclosure of a transfer plate;
Figure 2 shows a schematic disclosure of an exemplary use of the transfer method in a roll to roll process;
Figure 3 (A and B) shows a further detail of the transfer plate including a thermal shielding or thermal conduction layer;
Figure 4 shows a further embodiment, illustrating a side view of an electrically conductive busbar;
Figure 5 shows an alternative embodiment for a transfer plate having a planar resistive structure.
Figure 6 shows a practical embodiment of a print head;
Figure 7 shows a further embodiment of a rotatable print head; and
Figure 8 shows a repetition cycle for the transfer method as presently disclosed.

DETAILED DESCRIPTION

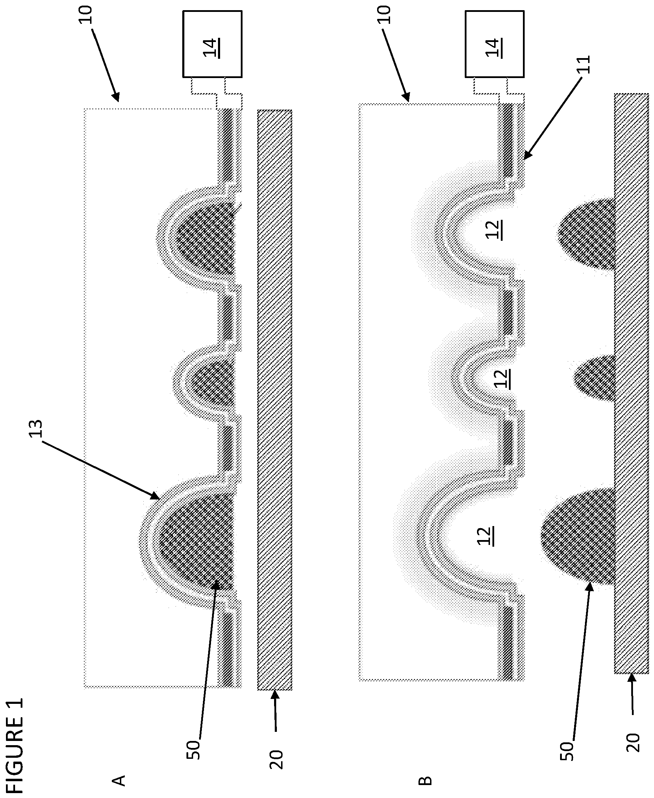

In an aspect, a direct write method is provided for high speed positioning die bonding material for discrete chip components on substrates, which can be operated in a reel to reel manufacturing fashion. In particular, the method can be used for high resolution deposition of highly viscous materials that can be deposited in thick layers with high aspect ratio features. With the attainable resolution of the disclosed methods and systems, that a resolution spot size of transferred die bonding material may be attained with a spot diameter of the transferred bonding material that is smaller than 50 micron. Figure 1 illustrates schematically an embodiment of a transfer method and device for a high viscosity functional material 50, such as a conductive paste, onto a receiving substrate (20), the method comprising the steps of: providing a plate 10 having a cavity surface 11 that includes at least one cavity 12, or providing a transfer device as disclosed herein. In the figure cavity 12 is provided with a resistive heating device 13. Control circuitry 14 is connected to said heating device 13 arranged to heat the resistive heating device 13. Functional material 50 is provided in cavity 12 that has a material composition that, when heated by the heating device, generates a gas at an interface between said cavity surface in the cavity and said functional material, to transfer said functional material from said at least one cavity 12 by said gas generation onto the receiving substrate 20. As illustrated further below, the method has sufficient accuracy to correct for web deformations of the flexible substrate 20. The term "flexible substrate" used in this text refers in particular to a substrate that is bendable enough to be used in a reel to reel process. In other words a flexible substrate as used in this text is a substrate that is flexible enough to allow bending over a certain curvature, e.g. with a radius of 1 - 100 centimeters (depending on the reel diameter), without the substrate losing essential functionality. Supply of chip bonding material matter 50 can e.g. be placed on a pad structure or on chip pads. The plate 10 having functional materials in the wells can be held at a distance away from the substrate. In contrast to prior art methods, the embodiments have as common concept that they provide for high speed high resolution bonding e.g. of micro-electronic components after placement thereof with their pads to respective pad structures of the substrate. This is a method that can be very efficient and cost effective for large scale industry purposes. Covering a selective part with conductive die bonding material has the function of providing a suitable electrical connection between the pad structure and conductive die. For example, a thermosettable isotropic conductive adhesive material can be transferred, as can be seen by in Figure 1a and 1b. having electrical conductivity on for instance coated Cu substrates or silver tracks with a volume resistivity of typically 4-10 E-4 Ohm.cm. To illustrate the general applicability of the method, an experimental conductive adhesive is transferred consisting of a highly viscous conductive adhesive with a viscosity of 160 - 180 Pa.s. The conductive adhesive can be provided as homogenous layer of 20-30 micron, in particular, 25 micron thick. The thickness is controlled to be around 25 um or 50 um but could be theoretically be of any thickness. For example, a cavity 12 may be in the order of 5-10 micron deep and may have a smallest diameter of less than 50 micron.

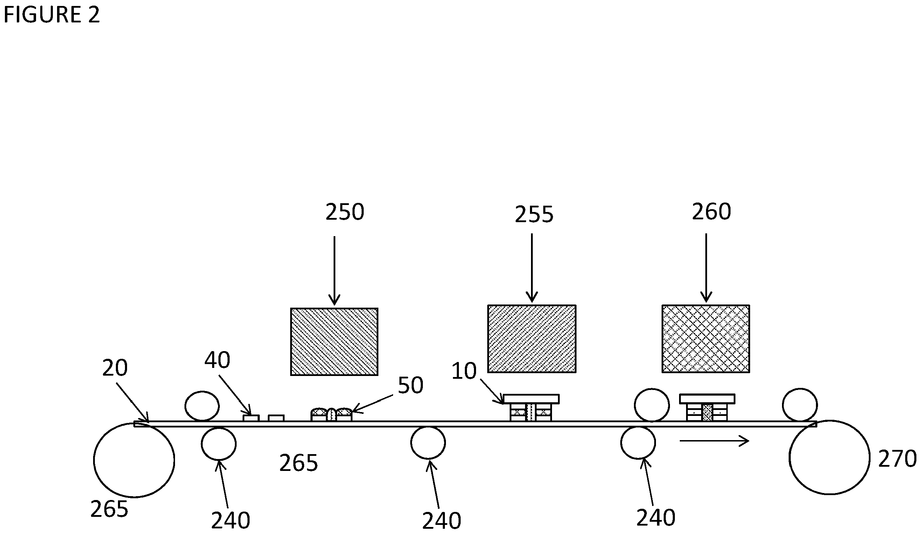

Figure 2 shows a schematic assembly process for a micro-electronic component 60 that includes transferring chip bonding and interconnect matter by the method in transfer section 250 as illustrated in the preceding. In particular, a bare chip component interconnection method is disclosed for the interconnecting and bonding a bare chip component 60 on a flexible substrate or foil 20 with conductive die attach matter 50 and nonconductive die attach matter 60. The method involves providing a flexible substrate 20 with contacts 40 and providing a bare chip component 60 with contacts to be placed on a predefined placement by positioning means 255. The method may involve a thermal exposure step 260 before the flexible substrate said foil is wound back onto the reel 270. In the disclosed reel to reel method of Figure 2, a substrate 20 or carrier web is unwound from a first reel 265 and guided via a set of guide rollers 240 to a second reel 270 to be wound up. In the unwound condition, various sub processes can be carried out, in particular, as one of the sub processes, bare chip component bonding as currently disclosed in the previous Figure 1. In particular, these sub processes may involve: - making 250 interconnects by the transfer method of a high viscosity conductive paste 50; - supply of a bare chip component 10, for example, a silicon based bare chip component or LED 10, to the target area on the substrate 20 by a pick and place unit 255 onto the interconnect material and controlling the pressure; - fixing of the die chip component 10 by a thermal curing unit 260 by thermosetting of the conductive non-conductive paste.

Non planar heating device

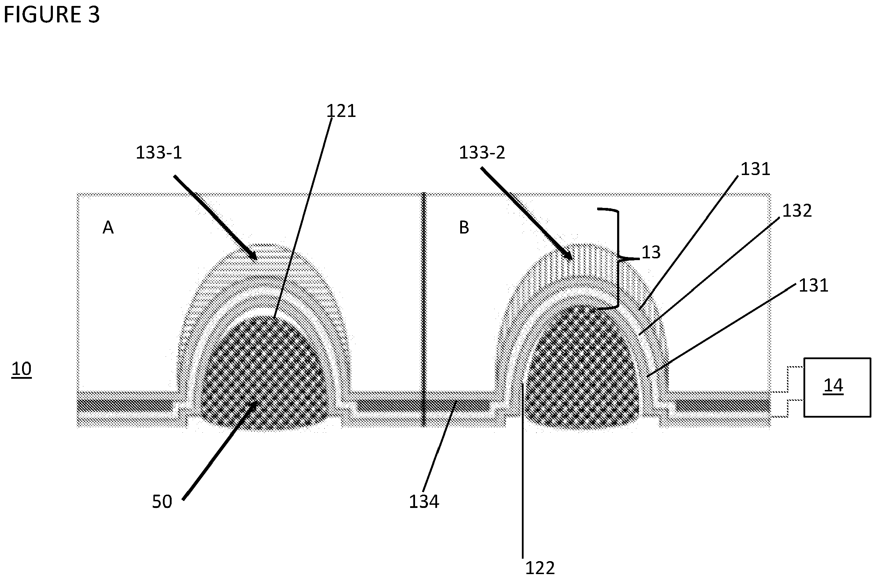

Figure 3 shows a further detail of the transfer plate including a thermal shielding part 133-1 or thermally conductive part 133-2. Electrical circuit 14 is coupled to the resistive device 13 formed by a layered stack of resistive layer conformal to the cavity sandwiched between conformal electrode layers the resistive layer and the electrode layers. For a good resistive heating contrast optimally said resistive layer and electrode layers differ in resistivity at least in a ratio of 100. The purpose of the electrical conductors is to carry the electric current to the heating devices in the cavities. It is important that the voltage drop over the conductors themselves are as low as possible. The current density is preferably as homogeneous as possible through the resistors so heating occurs in a uniform manner. When the resistance of the conductors is equal or higher than the resistance through the resistor, then it would mean that the conductors would be heated instead of the heating device. Therefore the resistance ratio (not resistivity) of the resistor and conductor may be as follows:

- Minimum ratio:    ~ 10
- Better ratio:        > 100
- Preferred ratio:    > 1000

The resistivity of the conductors may be 10-7 Ohmm or lower. By using the equation below the required resistivity of the conductor can be calculated based on the resistivity of the resistor and layer thicknesses. The transfer method uses an electric pulse from circuit 14 to rapidly heat a thin film resistor 132 to transfer a functional material 50 from carrier onto an acceptor substrate. For example, the control circuitry 14 is controlled to heat said heating device 13 in less than 100 microseconds at an average power of more than 10kW/cm2. The release method may be more effective if the control circuitry 14 allows for a pre heating step, prior to the gas generation step.

The thin film heating devices 13 are in this example only located in the recessed cavity parts of the transfer plate 10. When electric current flows through all the resistors, joule heating causes the solvent (or polymer) within the functional material to evaporate. This can be compared to the Leidenfrost effect, only in this case the heating is selective and for a very short time period (<100 $\mu$s). The patterned plate can be filled rapidly e.g. by using a doctor blade, whereupon the functional pattern is transferred onto a planar or non-planar substrate. The transfer plate material preferably has a low thermal conductivity in order to reduce heat sinking when the heating device is triggered. The lower the thermal conductivity of the plate (and paste), the more rapid and efficient the solvent can be evaporated. The functional material is heated at a heating rate of at least 0.5, preferably 5K/microsecond or even as high as 50K/microsecond in order to generate said gas at the interface but preferably as high as possible without damaging the resistor stack. This thermal shock means that the thermal expansion coefficient of the materials in the stack are closely matched to that of the plate 10 itself. Too high stresses in the thin film may lead to damage or delamination.

In some cases it might be preferred to have different heating rates to control the ejection characteristics of the paste. For example, it might be beneficial when the paste releases on the sides a little bit earlier than the top. This can be achieved by embedding the resistor in a selectively coated heat reflective layer 133-1, 133-2 or thermal insulation layer 133-1 or 133-2 (see Figure 3). Accordingly, the heat reflective layer 133 may locally adapted to the cavity 12, to guide a heat flux into the cavity. Alternatively, the resistive layer 132 may have a varying electric resistivity locally adapted to the cavity 12. Considering a desired heat flux, desired layer thickness and the maximum voltage, the resistivity of the resistor material is calculated. The maximum voltage is dependent on the dielectric strength of resistive layer. Similar to the insulator, the thickness of the resistive layer should not be too thick. When the layer is too thick, the thermal mass increases, which limits the heating rate. Moreover, when there are differences in thermal expansion between the plate material, conductor and resistor, the thermally induced stresses are more likely to damage (delamination, cracks) thicker layers because of higher acting forces. Thickness requirements for both the resistor and insulator:

- Maximum thickness: ~ 5000 nm
- Better thickness: < 500 nm
- Preferred thickness: < 50 nm

$$\rho_r = \frac{AU^2}{Pt_r}$$

Where $\rho_r$ is the resistivity of the resistor in Ohmm, A is the resistor area (m2), U is the voltage over the resistor in volts (V), P is the power in watts (W) and $t_r$ is the thickness in meters (m).

Typically the resistivity value is in the order of $10^{-2}$ - $10^6$ Ohmm to enable high heat fluxes with thin layers. It is important that during the entire heating process the resistance through the resistor is always higher than the resistance through the conductor.

E.g. in Figure 3 it is displayed that in example A, compared to example B, the thermal diffusivity of thermal insulator layer 133-1 is lower in the bottom of the cavity, than compared to the side walls. In Example B, conversely, the bottom of the cavity, the thermal insulator layer 133-2 has a higher thermal diffusivity. Conformal electrode layers 131 may be wired in a wiring pattern to address a resistive device 13 individually per cavity 12 or group of cavities, to selectively transfer said functional material 50 from a selected cavity or group of cavities.

When using a glass or quartz carrier plate, the typical fluence to release a functional paste material can be in the order of 0.4 J/cm2 when the pulse width is 100 $\mu$s. This depends on the type of solvent used in the paste and how fast the resistor is being heated.

The power requirements are quite demanding for this process. For a 100 $\mu$s pulse, the required average power level may be around 10kW/cm2. However, the threshold fluence to release an ink can go down significantly when the average power level increases. The thin film resistor also allows to pre-heat the functional material before it is being ejected. This can be used to print hot melt polymers for example.

In order to deliver this power, a predefined voltage and current density is supplied to the plate. As the resistance across the entire thin film resistor is dependent on the patterns size and resistor material, the required voltage on the capacitors may vary from pattern to pattern. When the resistance of the resistor material is known, the total surface area of the thin film resistor can be calculated. Knowing the total surface area, the total required energy can be determined. Then Ohm's law is used to calculate the electrical power and voltage for the circuit 14. It is important that the voltage drop only occurs over the resistive layer, not in-plane of the conductors. This means that the conductors need to be highly conductive, many orders of magnitude higher e.g. 100 or more, than the resistive coating. A suitable example for an electrode layer may be molybdenum, e.g. 500 nm Mo that is very thin, to reduce thermal stress due to heating. A suitable example of a resistor may be SiC or GaN. These materials have comparable expansion coefficients. The resistive device 13 may be capped by a hardened layer e.g. a SiN layer, to reduce wear.

When the resistance is higher through the conductive layer, then joule heating will occur in this layer, which is undesired. For semiconductors (undoped) the resistivity drops significantly when the temperature increases. This negative temperature coefficient (NTC) effect could cause problems with respect to heating homogeneity. If the thickness of the resistor is not perfectly uniform, then heating will occur faster where the layer is thinnest. Hence the resistance will drop even further at that location and the current will primarily flow through that part of the resistor.

Therefore it is preferred to have a positive temperature coefficient (PTC), meaning that the resistance increases and power consumption decreases with temperature. To obtain a PTC with a resistivity in the range of 10-2 - 106 Ohmm it is possible to use a doped semiconductor (e.g. silicon, silicon carbide and gallium nitride). However, typically the resistivity of PTC materials is relatively low, which would mean that the resistance requirements of the conductive layer will become more demanding. Ideally the resistor is made out a of a material with a high resistivity (10^0 - 10^2 Ohmm) which has a PTC behavior between 20C and 400C.

Besides a single resistor (doped semiconductor) material, it is also possible to use a stack with multiple layers. For example Schottky barriers can be added.

Depending on the size of plate and the layer thicknesses and electrical resistivity of the resistor material can be calculated. If the voltage drop is still too high (for example when the plate is very big), through hole vias 143 can be added to connect the conductors to highly conductive busbars 144 at the backside of the plate e.g. to an alternative circuit 144.

Planar heating device

In contrast to the Figure 3 embodiment, Figure 4 shows a further embodiment wherein the resistive device is provided as a resistive layer 132 parallel to the plate 10. The resistive layer is in thermal contact with a thermal conductor 122 provided in a thermal insulator layer of the plate parallel to the resistive layer; said thermal conductor forming the cavity 12. The thermal conductor functions as a heat spreader or heat flux reflector to spread the heat from resistive layer 123 towards cavity 12.

As it is difficult to design local heaters for complex printing patterns, resistive layer preferably covers a full area of the plate 10 for ease of manufacturability, but may also be patterned in smaller areas on plate 10.

To make sure the resistive layer 132 does not overheat and damage the plate where there is no heat spreader 122, the carrier substrate plate 10 may be provided in some embodiments from a high thermally conductive material, such as silicon. This allows heat from resistive layer 132 to diffuse into the carrier where there is no printing pattern, which limits the peak temperature of the heater itself, and avoids high peak temperature (overheating) at bottom of the plate.

Also, when there is residual paste on this surface, it is desired to prevent this material from transferring, drying or curing.

In order to further create high temperatures in the heat spreaders/ thermal conductor 122, the transfer device 100 further comprises a heat flux reflector part 133 aimed at directing heat flux towards the cavity 12. Heat flux reflector part 133 may be a thermal insulator, opposite the cavity at least, a part that has a relative high thermal insulation contrast relative to the further plate 10, e.g. of glass (Silica or the like) heat flux reflector parts embedded in a silicon plate. Such heat flux reflector parts may have a thickness of e.g. 3-5 micron, but other dimensions (up to 100 micron) may also work. Thus the heat flux reflector provides a thermal buffer on top of the cavity 12 to direct the heat to the downwards to the cavity 12. This creates a high thermal contrast between the patterned and un-patterned parts of the plate 10.

It will be clear that the plate 10, like for non-planar embodiments, may be formed of a material having a low thermal conductivity, e.g. glass (silica or the like). Forming the plate of a material having a low thermal conductivity increases thermal contrast between an outer surface of the plate and the cavity having a thermoconductive material that extends along and is restricted to the cavity. Forming the plate of a material having a low thermal conductivity further reduces, heat sinking, transfer of heat into the plate when the heating device is triggered, which improves transfer of heat towards the cavity for a given energy pulse as compared to devices having a plate formed of a thermoconductive material.

Highly conductive busbars 144 (e.g. of copper) can be added into the plate 10 to reduce the required voltage for achieving a high heat flux, which is advantageous as high operating voltages may increase a chance for electrical breakdown between adjacent heaters. In the example, busbars 144 draw a planar current by alternately wiring anode and cathode busbars e.g. distanced over the cavity structures 12 and at a distance therefrom to prevent thermal conduction to the busbars, as indicated in the Figure. Depending on the conductive nature of the plate resistive layer 132 may be electrically shielded by additional electrical insulator layers 134 on opposite sides.

In an example, the thermal conductor 122 completely forms the cavity, which may for example be at least 5 micron deep, and may be in thermal contact only at the bottom of the cavity, which may be planar conforming the planar resistive layer 132.

A cavity having a thermal conductor 122 that extends along the cavity and is limited thereto, e.g. as shown, can be manufactured by a number of methods. These include microfabrication methods such as local deposition e.g. by masking. Advantageously, the cavities with the thermal conductor 122 can be cost-effectively and accurately manufactured by a process including the following steps: i) patterning the thermal insulator layer of the plate parallel to the resistive layer to form cavities; ii) depositing a thermal conductor, e.g. a blanket layer, of desired thickness covering the thermal insulator layer and extending along the cavities; and iii) removing the thermal conductor outside the cavities along the plate, e.g. by grinding or polishing.

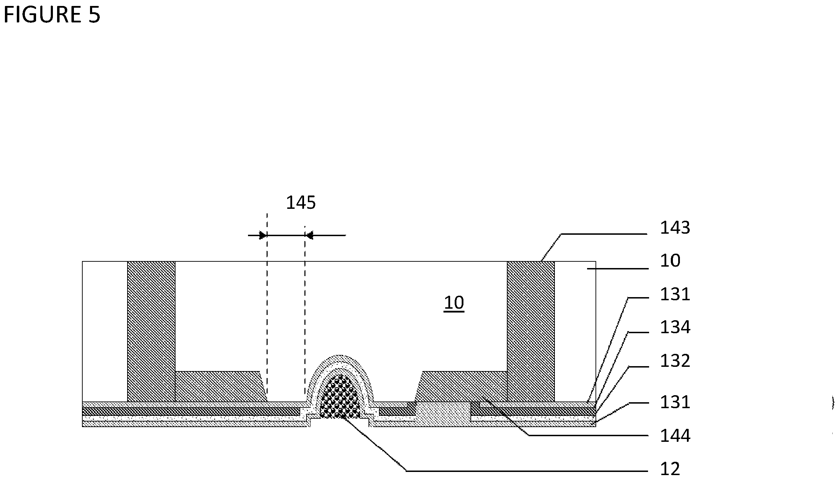

Figure 5 shows a further embodiment, in this case including a non-planar heating device , illustrating a side view of an electrically conductive busbar 144. Similar considerations apply for a planar heating device as illustrated in Figure 4 so the structure is not dependent on the particular shape of the heating device. A thermally insulating gap is provided between a distal end of the busbar 144 and the cavity 12, reducing thermal conductivity to and from the cavity 12. The spacing, gap distance, between the cavity and the busbar 144 is typically at least 10 micrometers, e.g. at least 50 micrometers, e.g. in a range up to 500 micrometers, e.g. between 100 and 500 micrometers. Other spacings, e.g. at least 5 micrometers, can be suitable as well. Suitable spacings can, for example, be determined by a measured or modelled thermal conductivity or heat profile along the plate 10 between the cavity and the busbar. As the electrical conductivity and thermal conductivity are strongly correlated to each other, it is desired to make the conductive layers 131 on the printing plate 10 as thin as possible to limit lateral heat flow away from the cavity or groove 12. For thick electrical conductive layers this means that the inside of the cavity may get much warmer than at the edges. This results in an inhomogeneous release pattern of the ink, sticking at the edges for longer than inside. Recommendable thickness dimensions of the conductive layer 131 are, for the conductor at a resistivity of 10-7 Ohmm or lower:

- Maximum thickness: $\sim$ 2000 nm
- Better thickness: < 500 nm


- Preferred thickness: < 100 nm

However, using thin conductive layers 131 may cause problems when the pattern is scaled up to larger areas. Preferably a homogeneous current density distribution is achieved with a minimal voltage drop. When the printing plate 10 becomes larger, the voltage drop may become much more significant. As the conductivity of the conductors and layer thickness in the cavities is limited, a solution to reduce the sheet resistance is by adding highly conductive busbars or increased thickness of the conductive layers away from the cavity 12. The busbars 144 may be embedded into the printing plate to keep a flat topology.

A thermally insulating gap 145 may span a distance between the cavity and conductors: e.g. in an embodiment of copper conductors on a glass substrate, in relation to specific values of thermal diffusivity:

Thermal diffusivity glass: 0.5 - 1.5 mm2/s
Thermal diffusivity copper: 111 mm2/s

A minimum gap distance is about $\sim$ 1 $\mu$m or higher, preferably, larger than 10 $\mu$m, or even larger than 100 $\mu$m.

The higher the heat flux in the cavity the smaller the distance can be without any heat sink effects that influence the printing process.

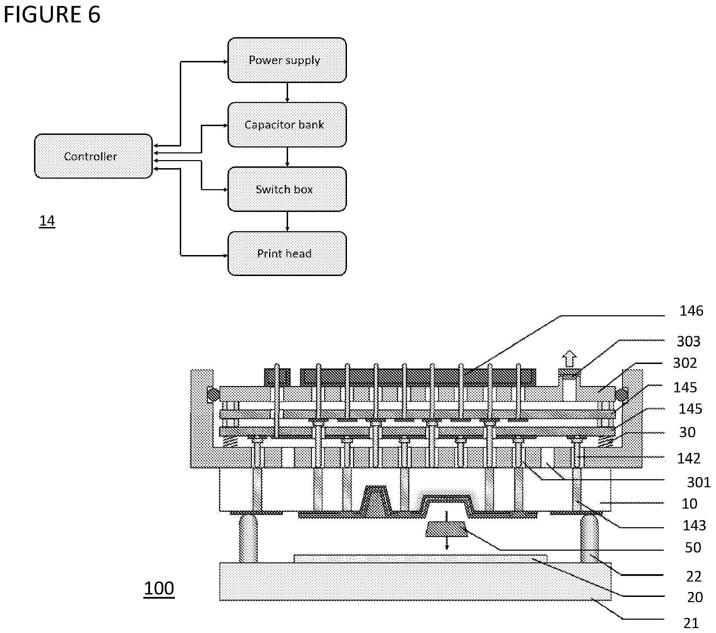

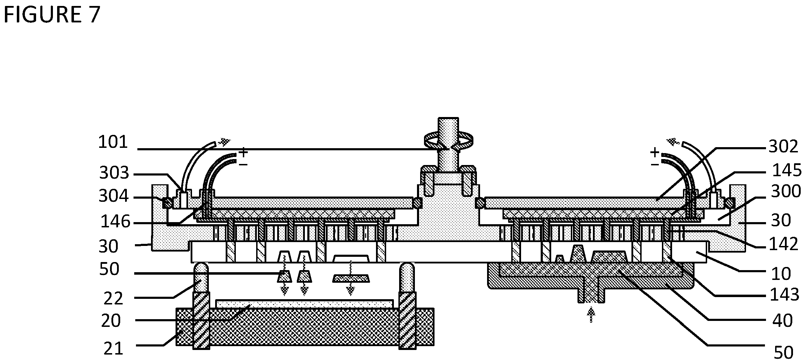

Figure 6 and 7 show practical embodiments of a print head 100 including control circuitry 14. The electric power supply 14 is designed to generate a large amount of power into the print plate 10. The print plate is positioned opposite a substrate 20, preferably through spacers 22 on a substrate holder or table 21. For example the wiring pattern may have contact pads 142, that correspond to a terminal configuration of an electrical power supply 141, wherein the contact pads 142 are brought in contact with the terminal configuration by moving the substrate 10 relative to the terminal configuration 141. Contact pads 142 connect to the conductive layers 131 by vias 143.

It is preferred to operate at high voltages to reduce the current density. However, the maximum voltage is limited by the dielectric strength and thickness of the insulator layer. Too high voltages will lead to electrical breakdown between the two electrodes. As a non limiting example, at a film thickness of 1 $\mu$m, silicon dioxide can have a dielectric strength of 0.5GV/m. This means that the at this thickness the maximum voltage would be 500V. High dielectric strength materials are desired as it allow to use high voltages while keeping the stack as thin as possible. The thinner the stack, the fewer topology and thermal problems next to the cavities. For example, a thin undesired thin film of ink can be transferred or unwanted shear forces due to insufficient edge heating occur when the insulator film is relatively thick.

As a printing plate 10 is typically less than 1 mm thick, the dimensional stability of such a plate may be challenging, especially for larger plates (low aspect ratio, thickness versus width). This makes it difficult to control the printing gap over a large area. To control this gap, ideally the printing plate is pulled against a rigid and dimensionally stable vacuum chuck 30. This vacuum chuck 30 can be flat or curved (convex or concave) to hold the printing plate in position. Ideally the vacuum chuck has holes 301 for the electrically conductive pins to make contact with the via's in the printing plate 10. The vacuum chuck 30 can be cooled to maintain a stable printing temperature and has a vacuum sealing plate 302 sealed by seal 304 and having vacuum connection 303 that provide for electrical connections 146 to the control circuitry 14.

For automation, spacer pins 142 may generate a trigger signal when all of them are in touch with the printing plate 10. Connecting control circuitry 14 for top and bottom conductors and respective vias 143 are separated in separate circuitry boards 145, This means that the printing process can be immediately initiated when the correct sample holder is in the correct position. This speeds up the process and it ensures printing will only occur when there is a sample holder underneath. Triggering can be done electronically by means of a resistance measurement between the spacer pins 142.

The spacer pins need to be electronically connected and make electrical contact with triggering pads on the printing plate 10.

The electrical requirements for the print head 100 depend on the thermal diffusivity of the printing plate material. During the heating process heat will dissipate into the ink 50 and plate. The higher the thermal diffusivity, the higher the heat flux needs to be to generate a peak temperature at the ink/plate interface at which the solvent explosively evaporates. Typically this means going from room temperature to around 150 - 400C, depending on the solvent type in the ink.

Evaporation timescale requirements:

| Minimum time scale: | $\sim 1000\ \mu s$ |
| Better time scale: | $< 100\ \mu s$ |
| Preferred time scale: | $< 10\ \mu s$ |

When the boiling point of the inks' solvent is approached too slowly (> 1 ms), then the generated bubbles tend to be too big, which leads to more residue of solids at the interface between two bubbles. The faster the ink is being heated, the smaller the bubble sizes and will result in less residue (solids in the ink). It is important to limit the amount of residue because it enables printing multiple times in a stable manner without intermediate cleaning steps. For this reason high a high heat flux is preferred.

Heat flux requirements for a glass/quartz printing plate:

| Thermal diffusivity: | 0.5 - 1.5 mm2/s |
| Minimum heat flux: | $\sim 1$ kW/cm2 |
| Better heat flux: | > 10 kW/cm2 |
| Preferred heat flux | > 100 kW/cm2 |

At lower thermal diffusivities the required heat flux goes down (plastics), and at higher thermal diffusivities (metals) the required heat flux to locally heat the ink will go up significantly.

Besides using the resistive heaters for ejection, they can also be used to change the material properties of the functional ink. Heating will occur on a longer time scale to avoid boiling effects and bubble formation.

- Rapid temperature increase before printing to change viscosity with limited evaporation (tens of milliseconds)
- Evaporating solvent to increase viscosity and reduce mass (seconds)
- Curing of functional material, such as polymers (tens of milliseconds - minutes)
- Heating during filling process to improve flow into grooves (tens of milliseconds)

Figure 7 shows a further embodiment of a rotatable print head 101 provided flexibly on a rotatable face with a plurality of cavities, said plurality of cavities provided in patterns at least partly along a circumference of the rotatable face, so that, by rotation, a subsequent group of cavities from the plurality of cavities is brought in opposing position to the receiving substrate 20 prior to transferring the functional material 50 from the cavity onto the receiving substrate 20. A paste loading device 40 may provide the functional material 50 to the printing plate prior to rotating it to the substrate 20.

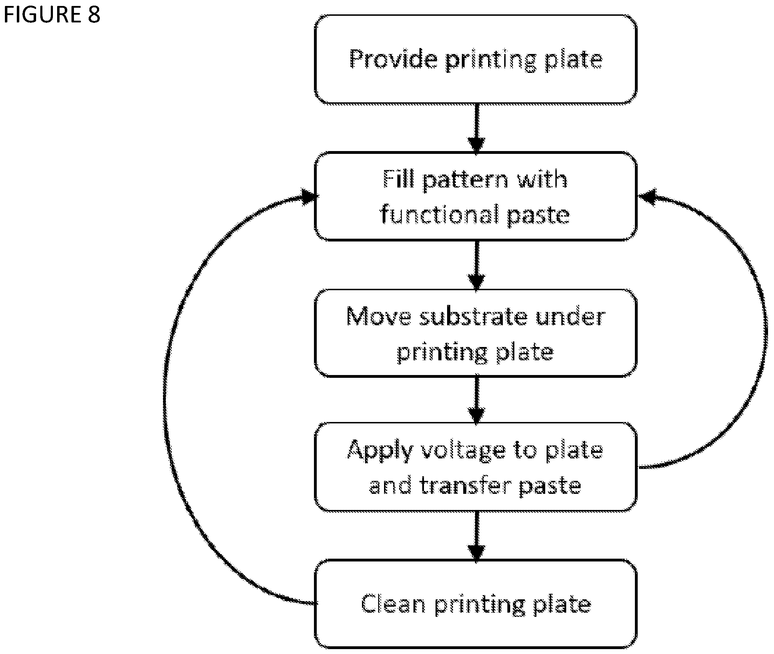

Figure 8 shows a repetition cycle for the transfer method as presently disclosed. This can be for example carried out by providing a printing plate on a rotatable drum surface with a plurality of cavities. A paste loading device may fill a pattern of cavities with a functional paste. The plurality of cavities are provided in patterns at least partly along a circumference of the rotatable drum surface, so that, by rotation of the drum, a subsequent group of cavities from the plurality of cavities is moved in opposing position to a receiving substrate prior to transferring the functional material from the cavity onto the receiving substrate. In a final step, the printing plate can be cleaned, prior to refilling the cavities with a subsequent load.

While the invention has been illustrated and described in detail in the drawings and foregoing description, such illustration and description are to be considered illustrative or exemplary and not restrictive; the invention is not limited to the disclosed embodiments. In particular, unless clear from context, aspects of various embodiments that are treated in various embodiments separately discussed are deemed disclosed in any combination variation of relevance and physically possible and the scope of the invention extends to such combinations.

Other variations to the disclosed embodiments can be understood and by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope. In addition, the functional material may have a widerange of viscosity, possible to transfer (from 50 Pa.s to 1000 Pa.s (non-exhaustive)). Contrary to stencil printing and screen printing it is a noncontact direct write method wherein the distance to the substrate surface is preferably kept higher than 1 micron. The transfer accuracy of the functional ink is dependent on the printing gap. Typically the printing gap needs to be in the same order as the feature size to obtain a good printing accuracy. When a small printing gaps are required, it becomes technically more difficult to align the print head with the sample holder. Therefore it is preferred to control the gap by using spacer pins and press the print head and sample holder together. It is preferred to have at least three degrees (heave, roll, pitch) of freedom between the print head and sample holder. In an example pastes can be formed as follows:

Solids content 90±5 wt%

| Material | Solids content | Purpose |
|---|---|---|
| Metal (Ag, Cu, Au): | **86.5**±5 wt% | Conductivity |
| Polymer binder | **2.5**±2 wt% | Adhesion and cohesion |
| Fumed silica | **1**±1 wt% | Anti-slump, rheology control |
| Solvent: | **10**±5 wt% | Printability |

with viscosities ranging between 100 en 1000 Pa*s. In contrast to conventional screen print paste and inks shear thinning may be minimized e.g. by adding fumed silica to prevent flow of the past on the acceptor substrate. This can also be prevented by curing/drying the ink e.g..by laser irradiation, which can be conveniently realized by a high solids content and low solvent content.

## Claims

1. A transfer device for transferring of a viscous functional material (50), such as a conductive paste, onto a receiving substrate (20), comprising:

   - a plate (10) having a cavity surface (11) that includes at least one cavity (12);
   - said cavity provided with a resistive heating device (13) and control circuitry (14) connected to said resistive heating device;
   said control circuitry arranged to, in use, heat the resistive heating device, so as to heat the functional material, provided in said at least one cavity, having a composition that, when heated, generates a gas at an interface between said cavity surface in the cavity and the functional material, to transfer said functional material from said at least one cavity by said gas generation onto a receiving substrate,
   wherein the resistive device is provided as a plate parallel resistive layer (132),
   **characterized in that** the cavity is formed in a thermal insulator layer (133) of the plate, wherein the cavity is provided with a thermal conductor (122) that is in thermal contact with the resistive device, and wherein said thermal conductor extends along, and is restricted to, the cavity surface.

2. The transfer device of claim 1, further comprising a heat flux reflector part aimed at directing heat flux towards the cavity, wherein optionally the heat flux reflector part is locally adapted to the cavity.

3. The transfer device of claim 1 or 2, wherein the resistive heating device is connected through a busbar structure to the control circuitry.

4. The transfer device of claim 3, wherein the busbar structure is provided with a thermally insulating gap between a distal end thereof and the cavity, thereby reducing thermal conductivity to and from the cavity to the busbar structure.

5. The transfer device of any of claims 1-4, wherein the resistive heating device is wired in a wiring pattern provided on said plate to address the resistive heating device individually per cavity or group of cavities, to selectively transfer said functional material from a selected cavity or group of cavities.

6. The transfer device according to claim 5, wherein the wiring pattern has contact pads on the plate opposite said cavity, corresponding to a terminal configuration of an electrical power supply, wherein the contact pads are brought in contact with the terminal configuration by moving the plate relative to the terminal configuration.

7. The transfer device according to any previous claim 1-6, wherein the plate is provided flexibly on a face of a rotatable drum, with a plurality of cavities, said plurality of cavities provided in patterns at least partly along a circumference of the rotatabledrum, so that, by rotation, a subsequent group of cavities from the plurality of cavities is brought in opposing position to the receiving substrate prior to transferring the functional material from the cavity onto the receiving substrate.

8. The transfer device of any of previous claims 1-7, further comprising a paste loading device, arranged to load the plurality of cavities with the functional material wherein optionally the paste loading device comprises a doctor blade.

9. The transfer device of any of previous claims 1-8, wherein the cavity is 1-1000 micron deep and has a smallest diameter ranging between 1 and 5000 micron

10. A transfer method of a viscous functional material, such as a conductive paste, onto a receiving substrate (20), the method comprising the steps of:

   - providing a transfer device according to any of claims 1-9;
   - providing a functional material in the at least one cavity, having a material composition that, when heated by the heating device, generates a gas at an interface between said cavity surface in the cavity and said functional material, to transfer said functional material from said at least one cavity by said gas generation onto the receiving substrate.

11. The transfer method of claim 10, wherein the control circuitry connected to said heating device is controlled to heat said heating device in less than 100 microseconds at an average power of more than 10kW/cm2.

12. The transfer method of claim 10 or 11, wherein the control circuitry executes a pre heating step, prior to the gas generation step.

13. The transfer method of any preceding claim 10-12, wherein the functional material is heated at a heating rate of at least 5K/microsecond in order to generate said gas at the interface.

14. The transfer method of any preceding claim 10-13, wherein said functional material is provided with a solvent and a solid state composition of more than 50 vol % solid state material.

15. The transfer method according to any preceding claim 10-14, wherein said functional material is a conductive material, such as an electroconductive polymer, a metallized polymer, a solder paste, conductive adhesive or adhesive.

**Patentansprüche**

1. Transfervorrichtung zum Transferieren eines viskosen funktionalen Materials (50), wie zum Beispiel einer leitfähigen Paste, auf ein Empfangssubstrat (20), umfassend:

   - eine Platte (10) mit einer Hohlraumoberfläche (11), die mindestens einen Hohlraum (12) beinhaltet;
   - wobei der Hohlraum mit einer Widerstandsheizvorrichtung (13) und einer mit der Widerstandsheizvorrichtung verbundenen Steuerschaltung (14) versehen ist;
   wobei die Steuerschaltung eingerichtet ist, um im Gebrauch die Widerstandsheizvorrichtung zu erwärmen, um das in dem mindestens einen Hohlraum vorgesehene funktionale Material zu erwärmen, das eine Zusammensetzung aufweist, die bei Erwärmen ein Gas an einer Grenzfläche zwischen der Hohlraumoberfläche in dem Hohlraum und dem funktionalen Material erzeugt, um das funktionale Material aus dem mindestens einen Hohlraum durch die Gaserzeugung auf ein Empfangssubstrat zu transferieren,
wobei die Widerstandsvorrichtung als plattenparallele Widerstandsschicht (132) vorgesehen ist,
**dadurch gekennzeichnet, dass** der Hohlraum in einer thermischen Isolierschicht (133) der Platte ausgebildet ist, wobei der Hohlraum mit einem thermischen Leiter (122) versehen ist, der in thermischem Kontakt mit der Widerstandsvorrichtung steht, und wobei sich der thermische Leiter entlang der Hohlraumoberfläche erstreckt und auf diese beschränkt ist.

2. Transfervorrichtung nach Anspruch 1, ferner umfassend ein Wärmestromreflektorteil, das darauf abzielt, den Wärmestrom auf den Hohlraum zu lenken, wobei das Wärmestromreflektorteil optional lokal an den Hohlraum angepasst ist.

3. Transfervorrichtung nach Anspruch 1 oder 2, wobei die Widerstandsheizvorrichtung über eine Stromschienenstruktur mit der Steuerschaltung verbunden ist.

4. Transfervorrichtung nach Anspruch 3, wobei die Stromschienenstruktur mit einem wärmeisolierenden Spalt zwischen ihrem distalen Ende und dem Hohlraum versehen ist, wodurch die Wärmeleitfähigkeit zu und von dem Hohlraum zu der Stromschienenstruktur verringert wird.

5. Transfervorrichtung nach einem der Ansprüche 1 bis 4, wobei die Widerstandsheizvorrichtung in einem auf der Platte vorgesehenen Verdrahtungsmuster verdrahtet ist, um die Widerstandsheizvorrichtung individuell pro Hohlraum oder Gruppe von Hohlräumen anzusprechen, um das funktionale Material selektiv aus einem ausgewählten Hohlraum oder einer Gruppe von Hohlräumen zu transferieren.

6. Transfervorrichtung nach Anspruch 5, wobei das Verdrahtungsmuster Kontaktflächen auf der Platte gegenüber dem Hohlraum aufweist, die einer Anschlusskonfiguration einer elektrischen Stromversorgung entsprechen, wobei die Kontaktflächen durch Bewegen der Platte relativ zu der Anschlusskonfiguration in Kontakt mit der Anschlusskonfiguration gebracht werden.

7. Transfervorrichtung nach einem der vorhergehenden Ansprüche 1 bis 6, wobei die Platte flexibel auf einer Fläche einer drehbaren Trommel mit einer Vielzahl von Hohlräumen versehen ist, wobei die Vielzahl von Hohlräumen in Mustern zumindest teilweise entlang eines Umfangs der drehbaren Trommel vorgesehen ist, so dass durch Drehung eine nachfolgende Gruppe von Hohlräumen aus der Vielzahl von Hohlräumen in eine dem aufnehmenden Substrat gegenüberliegende Position gebracht wird, bevor das funktionale Material aus dem Hohlraum auf das Empfangssubstrat transferiert wird.

8. Transfervorrichtung nach einem der vorhergehenden Ansprüche 1 bis 7, ferner umfassend eine Pastenladevorrichtung, die eingerichtet ist, um die Vielzahl von Hohlräumen mit dem funktionalen Material zu beladen, wobei die Pastenladevorrichtung optional eine Rakel umfasst.

9. Transfervorrichtung nach einem der vorhergehenden Ansprüche 1 bis 8, wobei der Hohlraum 1-1000 Mikrometer tief ist und einen kleinsten Durchmesser zwischen 1 und 5000 Mikrometer hat.

10. Transferverfahren für ein viskoses funktionales Material, wie eine leitfähige Paste, auf ein Empfangssubstrat (20), wobei das Verfahren die folgenden Schritte umfasst:

   - Bereitstellen einer Transfervorrichtung nach einem der Ansprüche 1 bis 9;
   - Bereitstellen eines funktionalen Materials in dem mindestens einen Hohlraum, das eine Materialzusammensetzung aufweist, die bei Erwärmen durch die Heizvorrichtung ein Gas an einer Grenzfläche zwischen der Hohlraumoberfläche in dem Hohlraum und dem funktionalen Material erzeugt, um das funktionale Material aus dem mindestens einen Hohlraum durch die Gaserzeugung auf das Empfangssubstrat zu transferieren.

11. Transferverfahren nach Anspruch 10, wobei die mit der Heizvorrichtung verbundene Steuerschaltung gesteuert wird, um die Heizvorrichtung in weniger als 100 Mikrosekunden mit einer Durchschnittsleistung von mehr als 10 kW/cm2 aufzuheizen.

12. Transferverfahren nach Anspruch 10 oder 11, wobei die Steuerschaltung vor dem Schritt des Gaserzeugens einen Schritt des Vorheizens ausführt.

13. Transferverfahren nach einem der vorhergehenden Ansprüche 10 bis 12, wobei das funktionale Material mit einer Heizrate von mindestens 5K/Mikrosekunde erhitzt wird, um das Gas an der Grenzfläche zu erzeugen.

14. Transferverfahren nach einem der vorhergehenden Ansprüche 10 bis 13, wobei das funktionale Material mit einem Lösungsmittel und einer Festkörperzusammensetzung von mehr als 50 Volumenprozent Festkörpermaterial versehen ist.

15. Transferverfahren nach einem der vorhergehenden Ansprüche 10 bis 14, wobei das funktionale Material ein leitfähiges Material ist, wie ein elektrisch leitfähiges Polymer, ein metallisiertes Polymer, eine Lötpaste, ein leitfähiger Klebstoff oder ein Klebstoff.

**Revendications**

1. Dispositif de transfert pour transférer un matériau fonctionnel visqueux (50), tel qu'une pâte conductrice, sur un substrat récepteur (20), comprenant :

   - une plaque (10) ayant une surface à cavité (11) qui comporte au moins une cavité (12) ;
   - ladite cavité étant pourvue d'un dispositif chauffant résistif (13) et d'un montage de commande (14) connecté audit dispositif chauffant résistif ;
   ledit montage de commande étant agencé pour, en utilisation, faire chauffer le dispositif chauffant résistif, afin de chauffer le matériau fonctionnel, placé dans ladite au moins une cavité, ayant une composition qui, lorsqu'elle est chauffée, produit un gaz au niveau d'une interface entre ladite surface à cavité dans la cavité et le matériau fonctionnel, pour transférer ledit matériau fonctionnel par ladite production de gaz de ladite au moins une cavité vers un substrat récepteur,
   dans lequel le dispositif résistif est fourni sous la forme d'une couche résistive parallèle plate (132), **caractérisé en ce que** la cavité est formée dans une couche d'isolant thermique (133) de la plaque, dans lequel la cavité est pourvue d'un conducteur thermique (122) qui est en contact thermique avec le dispositif résistif, et dans lequel ledit conducteur thermique s'étend le long de la surface de la cavité et est limité à cette dernière.

2. Dispositif de transfert selon la revendication 1, comprenant en outre une partie formant réflecteur de flux de chaleur destinée à diriger un flux de chaleur vers la cavité, dans lequel en option la partie formant réflecteur de flux de chaleur est adaptée localement à la cavité.

3. Dispositif de transfert selon la revendication 1 ou 2, dans lequel le dispositif chauffant résistif est connecté au montage de commande par l'intermédiaire d'une structure de barre omnibus.

4. Dispositif de transfert selon la revendication 3, dans lequel la structure de barre omnibus est pourvue d'un espace thermiquement isolant entre une extrémité distale de celle-ci et la cavité, réduisant ainsi la conductivité thermique de et vers la cavité vers la structure de barre omnibus.

5. Dispositif de transfert selon l'une quelconque des revendications 1 à 4, dans lequel le dispositif chauffant résistif est câblé dans un motif de câblage placé sur ladite plaque pour activer le dispositif chauffant résistif individuellement par cavité ou groupe de cavités, pour transférer de manière sélective ledit matériau fonctionnel d'une cavité sélectionnée ou d'un groupe de cavités sélectionné.

6. Dispositif de transfert selon la revendication 5, dans lequel le motif de câblage comporte des plages de contact sur la plaque en face de ladite cavité, correspondant à une configuration de bornes d'une alimentation électrique, les plages de contact étant mises en contact avec la configuration de bornes en déplaçant la plaque par rapport à la configuration de bornes.

7. Dispositif de transfert selon l'une quelconque des précédentes revendications 1 à 6, dans lequel la plaque est placée de façon flexible sur une face d'un tambour rotatif, avec une pluralité de cavités, ladite pluralité de cavités étant formée selon des motifs au moins en partie le long d'une circonférence du tambour rotatif, de sorte que, par rotation, un groupe consécutif de cavités de la pluralité de cavités est mis en position d'opposition par rapport au substrat récepteur avant le transfert du matériau fonctionnel de la cavité au le substrat récepteur.

8. Dispositif de transfert selon l'une quelconque des précédentes revendications 1 à 7, comprenant en outre un dispositif de chargement de pâte, agencé pour charger la pluralité de cavités avec le matériau fonctionnel, dans lequel en option le dispositif de chargement de pâte comprend un racloir.

**9.** Dispositif de transfert selon l'une quelconque des précédentes revendications 1 à 8, dans lequel la cavité a une profondeur de 1 à 1000 micromètres et a un plus petit diamètre compris entre 1 et 5000 micromètres.

**10.** Procédé de transfert d'un matériau fonctionnel visqueux, tel qu'une pâte conductrice, sur un substrat récepteur (20), le procédé comprenant les étapes suivantes :

- fournir un dispositif de transfert selon l'une quelconque des revendications 1 à 9 ;
- placer un matériau fonctionnel dans ladite au moins une cavité, ayant une composition de matériau qui, lorsqu'elle est chauffée par le dispositif chauffant, produit un gaz au niveau d'une interface entre ladite surface à cavité dans la cavité et ledit matériau fonctionnel, pour transférer ledit matériau fonctionnel par ladite production de gaz de ladite au moins une cavité vers le substrat récepteur.

**11.** Procédé de transfert selon la revendication 10, dans lequel le montage de commande connecté audit dispositif chauffant est commandé pour faire chauffer ledit dispositif chauffant en moins de 100 microsecondes avec une puissance moyenne supérieure à 10 kW/cm2.

**12.** Procédé de transfert selon la revendication 10 ou 11, dans lequel le montage de commande exécute une étape de préchauffage, avant l'étape de production de gaz.

**13.** Procédé de transfert selon l'une quelconque des précédentes revendications 10 à 12, dans lequel le matériau fonctionnel est chauffé avec une vitesse de chauffage d'au moins 5 K/microseconde pour produire ledit gaz au niveau de l'interface.

**14.** Procédé de transfert selon l'une quelconque des précédentes revendications 10 à 13, dans lequel ledit matériau fonctionnel est pourvu d'un solvant et d'une composition à l'état solide comprenant plus de 50 % en volume de matériau à l'état solide.

**15.** Procédé de transfert selon l'une quelconque des précédentes revendications 10 à 14, dans lequel ledit matériau fonctionnel est un matériau conducteur, tel qu'un polymère conducteur de l'électricité, un polymère métallisé, une pâte à braser, un adhésif conducteur ou un adhésif.

FIGURE 1

FIGURE 2

## FIGURE 3

EP 4 140 262 B1

FIGURE 4

EP 4 140 262 B1

144 144

10

143

132

134

133

122

50

100

FIGURE 5

# FIGURE 6

Power supply

Capacitor bank

Switch box

Print head

Controller

14

146
303
302
145
145
30
142
301
10
143
50
22
20
21

100

EP 4 140 262 B1

FIGURE 7

FIGURE 8

```
┌─────────────────────────┐
│  Provide printing plate  │
└─────────────────────────┘
              │
              ▼
┌─────────────────────────┐
│      Fill pattern with   │
│      functional paste    │
└─────────────────────────┘
              │
              ▼
┌─────────────────────────┐
│    Move substrate under  │
│       printing plate     │
└─────────────────────────┘
              │
              ▼
┌─────────────────────────┐
│    Apply voltage to plate│
│     and transfer paste   │
└─────────────────────────┘
              │
              ▼
┌─────────────────────────┐
│    Clean printing plate  │
└─────────────────────────┘
```

EP 4 140 262 B1

**EP 4 140 262 B1**

**REFERENCES CITED IN THE DESCRIPTION**

**Patent documents cited in the description**

- US 20170268100 A